# EUROPEAN PATENT SPECIFICATION

(11) **EP 1 863 079 B1**
(45) Date of publication and mention of the grant of the patent: **10.08.2011**
(21) Application number: 07010855.0
(22) Date of filing: 01.06.2007
(51) Int. Cl.: H01L 21/673

(54) **Apparatus with filet radius joints**
Vorrichtung mit Verbindungen mit ausgebuchtetem Radius
Appareil avec joints de rayon de filet

(30) Priority: 02.06.2006 US 810461 P
(43) Date of publication of application: 05.12.2007
(73) Proprietor: Rohm and Haas Electronic Materials, LLC, Marlborough, Massachusetts 01752 (US)
(72) Inventor: Pickering, Michael A., Dracut Massachusetts 01826 (US); Goela, Jitendra S., Andover Massachusetts 01810 (US); Triba, Jamie L., Nashua New Hampshire 03063 (US); Payne, Thomas, Woburn Massachusetts 01801 (US)
(74) Representative: Buckley, Guy Julian

(56) References cited:
- WO-A-00/24041
- US-A1- 2003 024 888

## Description

The present invention is directed to an apparatus for holding semiconductor wafers where the component parts of the apparatus are secured by joints having flanges with a fillet radius. More specifically, the present invention is directed to an apparatus for holding semiconductor wafers of which the component parts are secured by joints having flanges with a fillet radius which can withstand the harsh conditions of semiconductor wafer processing.

Processing of semiconductor wafers involves harsh conditions such as exposure to corrosive chemicals, high temperatures exceeding 1000° C and rapid thermal cycling (RTP). Such conditions may result in physical damage to the wafer holding apparatus such as weakening of the apparatus especially at points where the parts of the apparatus are joined such as at their connecting joints. The weakening of the joints typically result in visible cracks along the joint lines, especially where the component parts of the joint are at right angles to each other.

The harsh conditions also may cause surface damage to the apparatus such that particulate matter from the apparatus sloughs off and contaminates the semiconductor wafers. Contamination caused by particles sloughing off of the surface of the apparatus is common especially if the apparatus is coated with a material which is different than that of the apparatus, such as an apparatus of quartz coated with silicon or silicon carbide. Such coatings often crack or form particles under the harsh conditions of semiconductor processing thus damaging the apparatus and contaminating the wafers as well as the processing chambers. Cracks in coatings are especially common at the right angles of joints where component parts meet. Particulate material also may lodge in spaces between the components of the joints of the apparatus, especially if the joints include numerous parts.

Particle contamination of wafers also may occur if the wafer holding apparatus is improperly cleaned after use. During wafer processing the wafers as well as the wafer holding apparatus become coated with chemical materials such as silicon dioxide, silicon nitride or polysilicon film. Such materials are difficult to remove from the apparatus. The cleaning difficulty is compounded when the apparatus has numerous component parts, especially at the points where the parts are joined.

The semiconductor industry has recognized that silicon carbide can withstand the harsh conditions of semiconductor processing and that it is a superior material for wafer boats as opposed to materials such as quartz. U.S. 6,811,040 discloses a wafer holding apparatus composed entirely of monolithic, chemical vapor deposited silicon carbide. The rods of the boat which hold the semiconductor wafers during processing are secured to the end plates by dovetail joints. The apparatus does not use additional fasteners and parts such as bolts, clamps or nuts to secure the apparatus components. Optionally, each joint may be coated with chemical vapor deposited silicon carbide to prevent any particulate material from lodging in any spaces between the joint parts.

Although the silicon carbide apparatus described in U.S. 6,811,040 is an improvement over many other semiconductor wafer holding apparatus, the dovetail apparatus is less stable or rigid in the same plane as the length of the rods than in the other planes of the apparatus. During semiconductor processing, in addition to exposure to corrosive chemicals and high temperatures the harsh conditions of semiconductor wafer processing chambers may cause wafer holding apparatus to move or vibrate. This is typical during initial heat up when the temperature of the apparatus is rapidly raised from room temperature to temperatures exceeding 1000° C over periods of 15 minutes to 60 minutes. The wafer holding apparatus absorbs energy and dissipates it as heat and mechanical energy such as vibration. Such vibration is accentuated in planes where the apparatus are least stable. Vibration causes a shearing force where the dovetails and the endplates meet. After continued use the dovetail joints may loosen which may result in the rods becoming detached from the endplates. In addition to vibration, the manual handling of the boat also may cause the joints to loosen over time.

Another problem associated with the wafer boat is the difficulty in machining the dovetail. Silicon carbide is a hard ceramic material in contrast to many other types of ceramic materials used for semiconductor wafer apparatus. Machining, even with diamond tools, presents a challenge. Machining is especially difficult due to the tapered sides characteristic of dovetails.

WO 00/24041 discloses a one-piece molded resin carrier for receiving and holding a plurality of semiconductor wafers during an ultrasonic wafer cleaning process.

Although there are improved semiconductor wafer holding apparatus, there is still a need for semiconductor wafer holding apparatus with joints having improved tolerance of the harsh conditions of semiconductor wafer processing and which are easier to machine.

An apparatus according to claim 1 is provided including a plurality of rods secured at their opposite ends to respective endplates by joints, characterised in that the joints have flanges with a fillet radius.

In another aspect the apparatus includes a plurality of rods secured at opposite ends to respective endplates by joints having flanges with a fillet radius, each rod end has a tenon which is inserted into an inside face of the respective endplate through an elliptical port having the flange with the fillet radius around its circumference, each tenon is continuous with a shoulder of the rod at each end of the rod, each shoulder has a flat surface to abut a top surface of the flange with the fillet radius to form an interface between the flat surface of the shoulder and the top surface of the flange.

In another aspect the apparatus includes a plurality of rods secured at opposite ends to respective endplates by joints having a four sided flange with a fillet radius, each rod end has a tenon which is inserted into an inside face of its respective endplate through a rectangular port having the four sided flange with the fillet radius, each tenon is continuous with a shoulder of the rod at each end of the rod, each shoulder has a flat surface to abut a top surface of the flange with the fillet radius to form an interface between the flat surface of the shoulder and the top surface of the flange.

In a further aspect the apparatus includes a plurality of rods secured at opposite ends to respective endplates by joints having a three sided flange with a fillet radius, each rod has a tenon which is inserted laterally into a port in a side of the endplate, the three sided flange with the fillet radius defines the port on an inside surface of the endplate, each tenon is continuous with a shoulder of the rod at each end of the rod, each shoulder has a flat surface to abut a top surface of the flange with the fillet radius to form an interface between the flat surface of the shoulder and the top surface of the flange.

In an additional aspect the apparatus includes a plurality of rods secured at opposite ends to respective endplates by joints having a three sided flange with a fillet radius, each rod has a tenon with the three sided flange with the fillet radius, each rod is inserted laterally into a port in a side of the endplate such that each side of the three sided flange forms an interface with a side of the port.

The joints having the flanges with the fillet radius provide for an apparatus having increased strength in contrast to semiconductor wafer apparatus which do not have such joints. Additionally, coating reactants applied to apparatus in coating chambers form thicker and more uniform coatings on apparatus with joints having flanges with the fillet radius as opposed to joints with component parts at sharp angles to each other, such as at right angles. The thicker and more uniform coating adds further strength to the joints and the apparatus as a whole.
Figure 1 is a schematic of a side view of the joint with the fillet radius;
Figure 2 illustrates one embodiment of the semiconductor wafer holding apparatus showing the rods with teeth and endplates;
Figure 3 illustrates one embodiment of the semiconductor wafer holding apparatus showing the rods joined to an endplate and the fillet radius at each joint;
Figure 4 illustrates the embodiment where the joint has an elliptical port with an elliptical flange with the fillet radius and a tenon of the rod;
Figure 5 illustrates the embodiment where the rod is secured in the elliptical port and the fillet radius around the circumference of the port;
Figure 6 illustrates the embodiment where the joint has a rectangular four sided port with the flange having the fillet radius and a tenon of the rod;
Figure 7 illustrates the embodiment where the joint has a three sided port with a three sided flange having the fillet radius and a tenon being inserted laterally into the port;
Figure 8 illustrates the embodiment where the flange with the fillet radius is on the tenon of the rod and the rod is inserted into a three port laterally;
Figure 9A is a photograph of a joint coated with silicon carbide where the rod is joined to an endplate at a right angle; and
Figure 9B is a photograph of a joint coated with silicon carbide where the rod is secured to the endplate with a port having a flange with a fillet radius.

As used throughout this specification, the following abbreviations have the following meaning unless the context indicates otherwise: °C = degrees Centigrade; mm = millimeters; cm = centimeters; m = meters; 2.54 cm/inch; slpm = standard liters per minute; and torr = pressure required to support 1 mm of mercury at 0° C. All numerical ranges are inclusive and combinable in any order except where it is logical that such numerical ranges are constrained to add up to 100%.

The apparatus is a semiconductor wafer holding apparatus for the processing of semiconductor wafers. The apparatus includes a plurality of rods secured at their opposite ends to respective endplates by joints having flanges with a fillet radius. The fillet radius provides for a joint having increased strength in contrast to many conventional joints of semiconductor wafer holding apparatus. The fillet radius eliminates sharp corners at the interface of the joint where the rods meet the endplates. The elimination of sharp corners enables coatings to be deposited on the joints of the apparatus which are more uniform and thicker than joints having sharp corners. The more uniform and thicker coatings on the joints further strengthen the joints. The joints also reduce or eliminate shearing forces at the joints.

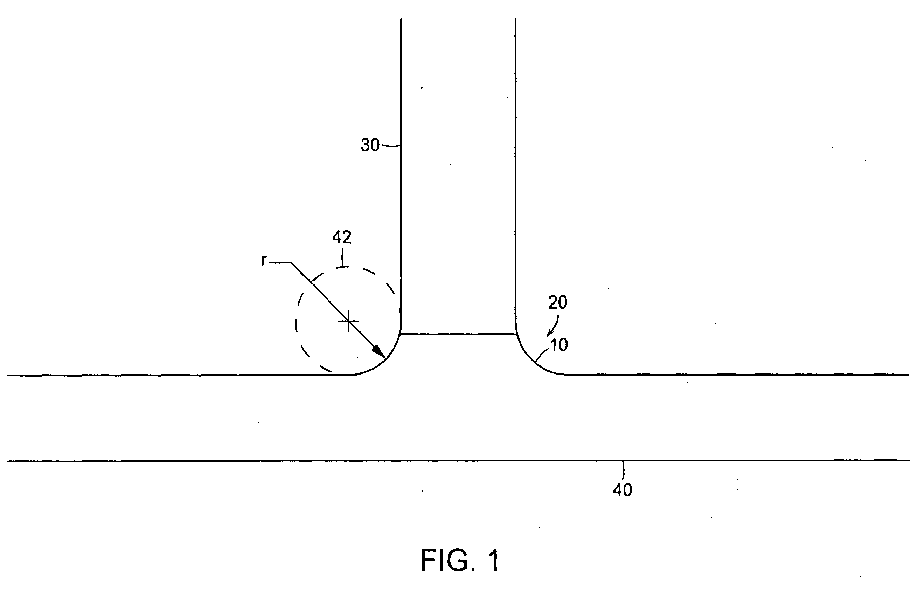

A fillet radius r of arc shaped flange **10** of joint **20** of the semiconductor wafer holding apparatus is illustrated in Figure 1. The Figure shows rod **30** inserted into endplate 40 forming joint 20 with fillet radius r of the flange defined by the distance from the tip of the arrow on a surface of the flange to the imaginary cross hairs. The dotted circle **42** indicates the best fit sphere. Typically the fillet radius ranges from 0.25 mm to 20 mm. More typically the fillet radius ranges from 1 mm to 10 mm. A fillet radius is a continuously curved concave junction formed where two surfaces meet. The fillet radius is measured by determining the surface contour of the fillet radius and then mathematically determining the best fit sphere to this contour. The radius of this best fit sphere is the fillet radius. The contour of the fillet radius surface can be measured using any technique, such as contact and non-contact profilometers, optical comparators or photographs that allows one to define the contour mathematically. Such methods are well known in the art.

The number of rods for supporting the semiconductor wafers may vary. Typically the semiconductor wafer holding apparatus includes three or four rods. More typically the number of rods is three. The rods include teeth which are separated by spaces where the semiconductor wafers are placed during processing. The endplates which secure the rods at their opposite ends may be of any suitable shape. Such shapes include, but are no limited to rectangular, elliptical and triangular. Optionally, the endplates may include holes which allow for the flow of gases across the wafers held in the apparatus during processing of the wafers.

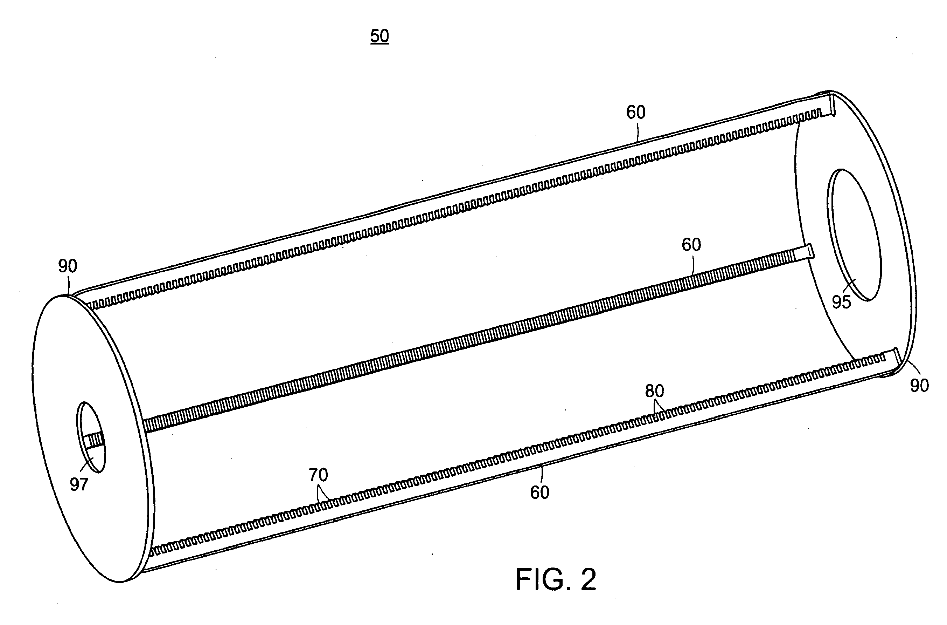

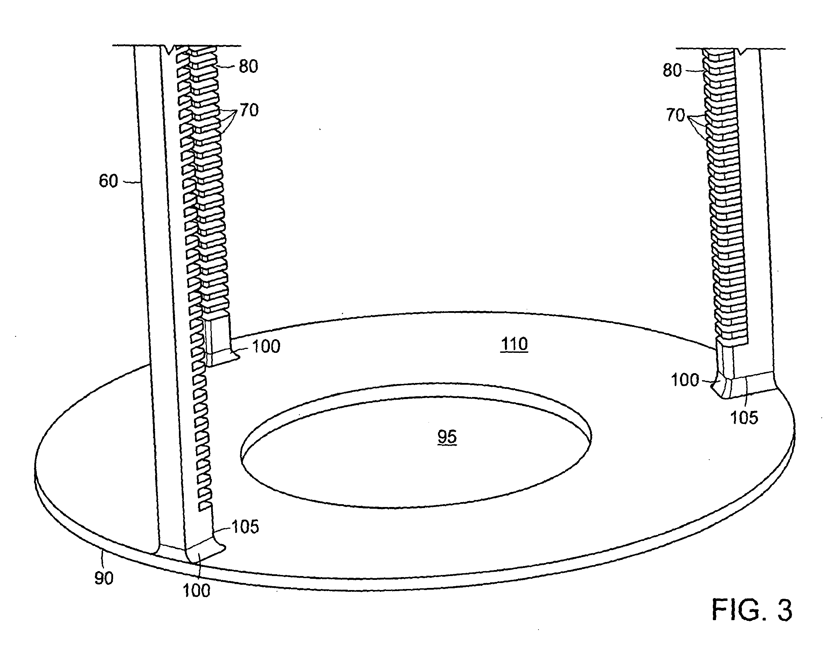

Figure 2 illustrates one embodiment of the semiconductor wafer holding apparatus. The apparatus **50** includes three rods **60** each having a plurality of teeth **70** separated from each other by spaces **80.** The rods **60** are joined to endplates **90** at their opposite ends. Each endplate has holes **95** and **97** for the flow of gases across wafers during semiconductor processing. The rods are joined to the endplates by joints having arced flanges with a fillet radius. Figure 3 illustrates the rods joined to the endplates and the flanges with the fillet radius.

Figure 3 is another view of the embodiment shown in Figure 2. Figure 3 shows one end of the apparatus with endplate 90 joined to rods 60 in ports with three sided flanges 100. The rods and the flanges join to form interface 105. The flanges are continuous with the inside face 110 of endplate 90.

The rods may be any suitable shape. Typically the rods are elliptical, rectangular or triangular. The rods terminate at their opposite ends with a tenon for inserting into ports in the endplates. The tenons are continuous with the rod and have a smaller diameter or width than the main body of the rod such that shoulders having flat surfaces are formed where the tenon joins the main body of the rod. In one embodiment shoulders of the rod meet with flat surfaces located on top of the arced flanges to form an interface when the rod is joined to the endplates.

The tenon may include a bore which is perpendicular to the length of the rod and passes entirely through the tenon. In another embodiment a side surface of the endplate has a bore which passes through the endplate and opens into a channel of the port where the tenon is inserted into the endplate. A second bore opposite the bore at the side surface of the endplate opens into the channel of the port. The tenon is inserted into the port such that the bore of the tenon is continuous with the bore of the side surface of the endplate and the second bore which opens into the channel. The continuous channel formed between the endplate and the tenon enables a pin to be inserted into the continuous channel to further secure the rod to the endplate.

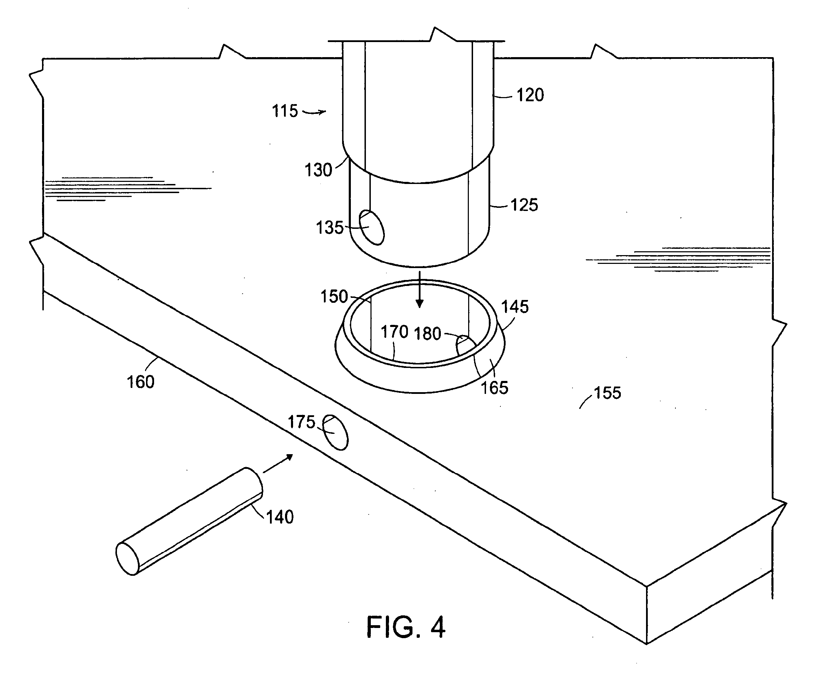

Figure 4 illustrates one embodiment which includes the pin for securing the rod to the endplate. Circular rod 115 includes the main body 120 of the rod and tenon 125. The tenon joins the main body of the rod at shoulder 130. The tenon 125 is continuous with the shoulder 130. The tenon includes bore 135 for inserting pin 140. Bore 135 passes through tenon 125. Flange 145, around the circumference of port 150 on the inside face 155 of endplate 160, has side 165 which is in the form of an arc and has a fillet radius. The tenon of the rod is inserted into port 150 such that the shoulder 130 of the rod meets top surface 170 of the flange and bore 135 forms a continuous channel with the bore 175 at the side surface of the endplate and a second bore of the endplate 180 which opens into port 150 opposite bore 175. Pin 140 is inserted into the continuous channel to further secure the rod in the port.

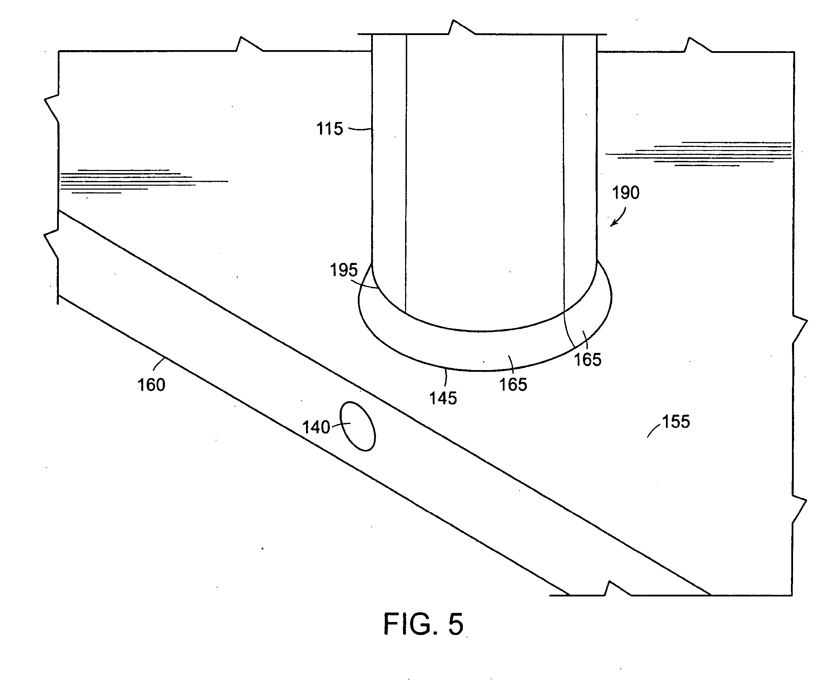

Figure 5 illustrates the assembled component parts forming joint 190. The circular rod 115 is inserted into the port to form interface 195 where the rod and the top surface of flange 145 meet to form the joint. As illustrated in Figure 5 Joint 190 does not have any sharp angles, such as right angles. The arced flange having a fillet radius eliminates the sharp angles to provide for a joint having increased strength.

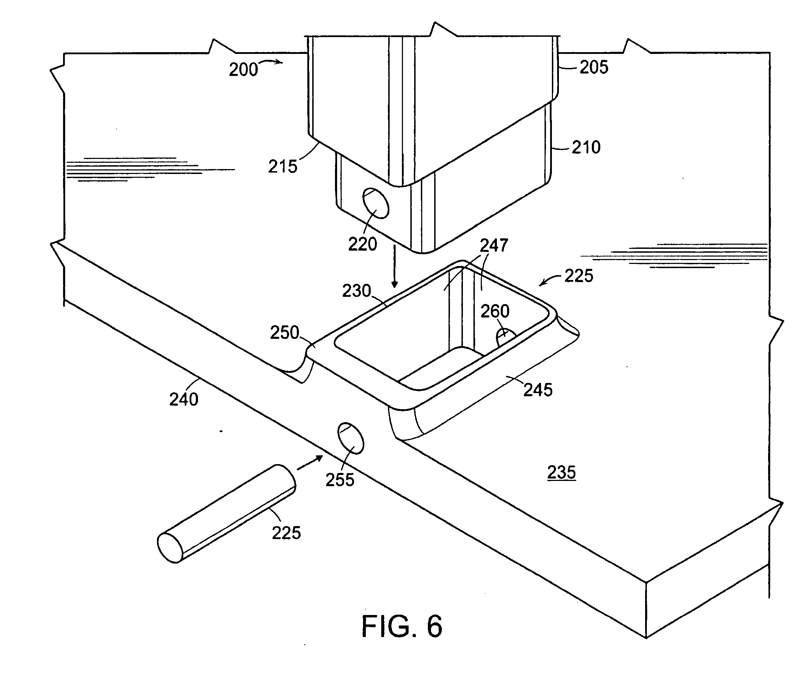

Figure 6 illustrates another embodiment where the pin is used to further secure the rod to the endplate. Rectangular rod **200** includes the main body **205** of the rod and rectangular tenon **210,** which has four faces. The tenon joins the main body of the rod at shoulder **215,** which has four surfaces. The tenon **210** is continuous with the shoulder **215.** The tenon includes bore **220** for inserting pin **225.** Bore **220** passes through tenon **210.** Rectangular flange **225** defines the boundaries of port **230** on the inside face **235** of endplate **240** and has sides **245** which are in the form of an arc and have a fillet radius. The port has four inner sides **247.** The tenon of the rod is inserted into port **230** such that the shoulder **215** of the rod meets surface **250** of the flange to form an interface and bore **220** forms a continuous channel with the bore **255** at the side surface of the endplate, which opens into port **230** and a second bore **260** of the endplate which opens into port **230** from an inner side of the port opposite bore **255.** Pin **225** is inserted into the continuous channel to further secure the rod in the port.

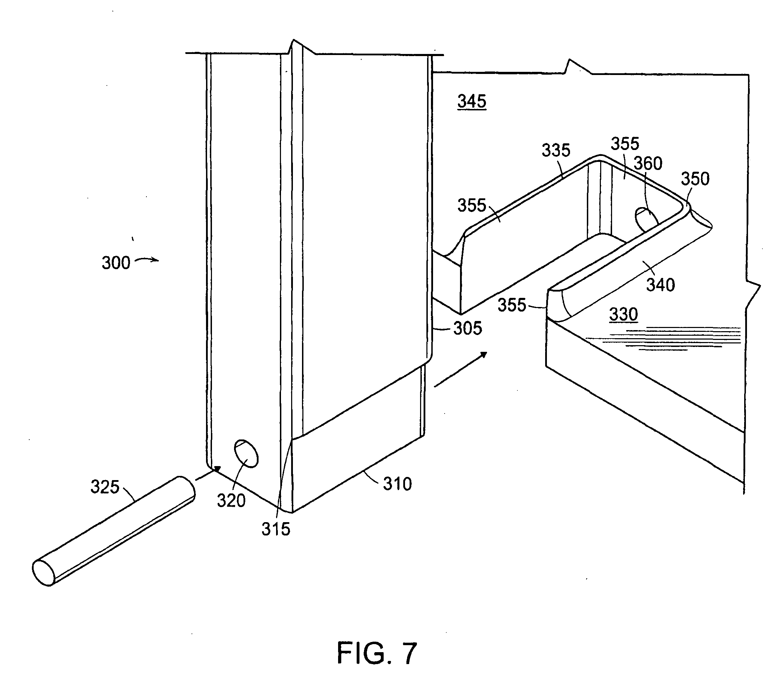

Figure 7 illustrates an additional embodiment where the pin is used to further secure the rod to the endplate. In this embodiment the rod is inserted laterally into the port in the endplate. The port of the endplate opens at a side of the endplate. Rectangular rod **300** includes the main body **305** of the rod and tenon **310.** The tenon joins the main body of the rod at shoulder **315.** The shoulder has three surfaces. The tenon **310** is continuous with the shoulder **315.** The tenon includes bore **320** for inserting pin **325.** Bore **320** passes through tenon **310.** A three sided flange **330** which defines the boundaries of port **335** has sides **340** which are in the form of an arc and have a fillet radius. The flange is on the inside face **345** of the endplate. The tenon of the rod is inserted laterally into port **335** such that the shoulder **315** of the rod meets the surface **350** of the flange to form an interface. Port **335** has three inner sides **355.** Bore **320** forms a continuous channel with a second bore **360** which opens into port **335.** Pin **325** is inserted into the continuous channel formed with bore **320** and second bore **360** to further secure the rod in the port.

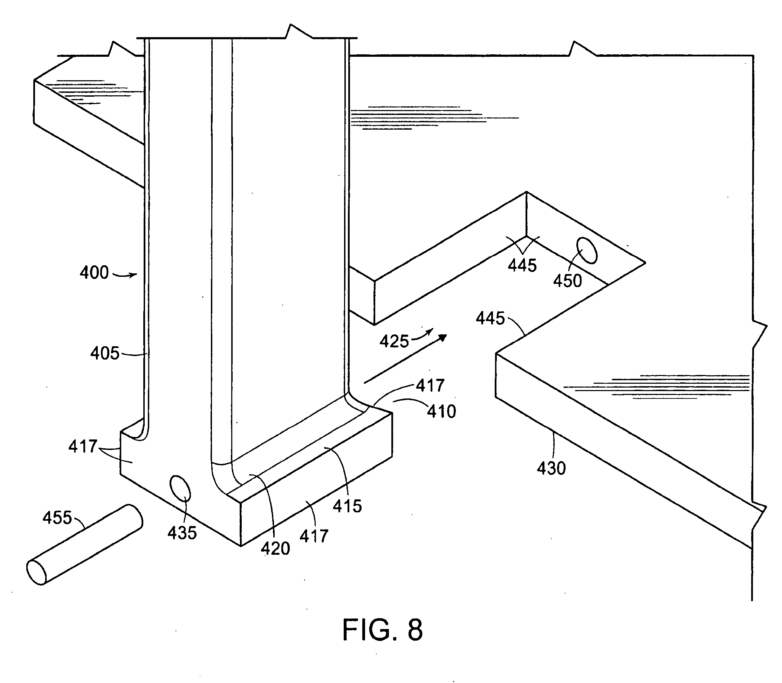

In a further embodiment the flanges having the fillet radius are on the tenon of the rod instead of defining the boundaries of the port. Figure 8 illustrates this embodiment. Rectangular rod **400** includes a main body **405** of the rod and tenon **410.** The tenon includes a flange **415** with four sides **417** and three upper surfaces **420** which are in the form of an arc and have a fillet radius. The tenon of the rod is inserted laterally into port **425** which opens at a side of endplate **430.** The tenon includes a bore **435** which passes through tenon **410.** The tenon of the rod is inserted into port **425** such that three of the sides **417** of the tenon meet three corresponding sides **445** of port **425** to form an interface between the three sides of the tenon and the three sides of the port. A second bore **450** in a side of the port of the endplate opposite bore **435** opens into port **425** to form a continuous channel with bore **435** in the tenon of the rod when the rod is inserted into the port. Pin **455** is inserted into the continuous channel to further secure the rod in the port.

The parts of the apparatus may be composed of any suitable type of silicon carbide. Typically the parts are composed of chemical vapor deposited silicon carbide. More typically, the parts of the apparatus are composed of chemical vapor deposited, cubic silicon carbide, and most typically the parts are composed of chemical vapor deposited, cubic β-crystalline silicon carbide. The cubic form of silicon carbide is most suitable for this application because the thermal expansion and thermal conductivity of cubic silicon carbide is isotropic (same in all directions), thus reducing thermal stresses in the apparatus when it is heated or cooled. Thermal stresses may lead to distortion of the apparatus causing damage to the wafers during processing and in severe cases the stresses may be high enough to cause the apparatus to fail (fracture).

The silicon carbide typically is monolithic because it is oxidation resistant, chemical resistant and thermal shock resistant. Additionally, such monolithic silicon carbide need not have any coating thus eliminating the potential for particles to slough off during semiconductor wafer processing and contaminate the wafers. The term monolithic means that the silicon carbide is a solid piece of silicon carbide. Such silicon carbide typically is formed by chemical vapor deposition where the solid piece is formed molecule by molecule by depositing the silicon carbide on a substrate typically referred to as a mandrel. The single piece is then removed from the mandrel by conventional means and machined to a desired size and shape. Methods of forming such monolithic chemical vapor deposited silicon carbide are well known in the art. Examples of such methods are disclosed in U.S. 5,354,580.

Minimal machining is employed in preparing the component parts of the semiconductor wafer holding apparatus. Shaping the parts of the joint and the grooves of the rods as well as the endplates involves less time and complexity than machining many single piece silicon carbide semiconductor wafer holding apparatus. Further, the joint secures the component parts of the apparatus without the need for additional mechanical components or undesirable chemical sealing agents.

Optionally the joints of the apparatus may be coated with silicon carbide to further strengthen the joints. Typically the joints are coated with 1 mm to 5 mm of silicon carbide. The silicon carbide may be deposited on the joints by conventional methods known in the art such as physical vapor deposition or chemical vapor deposition. The joint with the flanges having the fillet radius provide for a more uniform and thicker coating on the joint than joints having sharper angles where the component parts meet, such as at right angles. The more uniform and thicker coatings further increase the strength of the apparatus. For example, in a bulk chemical vapor deposition (CVD) process used to manufacture silicon carbide the CVD reactor is operated in a mass-transport limiting regime where the flow of chemical reactants across component surfaces has a great affect on the uniformity of the coating. A sharp corner, such as a right angle, at a joint causes a region of deficient flow causing reduced reactant flow and reduced coating deposition at the joint. By eliminating the shaper corner at the joint, reactant flow is improved with a more uniform deposition of coating and a thicker coating as well.

During semiconductor wafer processing the wafer holding apparatus along with the wafers in the apparatus are exposed initially to rapid temperature increase from room temperature to temperature exceeding 1000° C over periods of 15 minutes to 60 minutes. Typically the temperature increase from room temperature to as high as 1450° C over period of from 20 minutes to 45 minutes. Such rapid temperature increases cause energy to build up in the wafer holding apparatus at a rapid rate. The energy build up is dissipated by the apparatus in the form of heat and mechanical energy such as vibration. Such vibration typically occurs in the apparatus along its weakest or least stable planes. Typically this is along the plane or direction of the length of the rods. The present joint provides a stable joint in the plane of the rods including in other planes or directions to reduce or eliminate the vibration or motion.

The present joint provides sufficient strength and support for the apparatus such that it does not sag due to the weight of semiconductor wafers placed in the grooves. Thus, the apparatus of the present invention may be used to process multiple wafers by horizontal processes without concern for the problems associated with horizontal processing. Additionally the silicon carbide components enable the apparatus to be placed in vertical apparatus where multiple semiconductor wafers may be processed. Additionally, the size of the wafer holding apparatus is limited only by the size of the semiconductor wafer processing chamber employed.

The following example is intended to illustrate the invention and is not intended to limit its scope.

### Example

Three joints of chemical vapor deposited silicon carbide were prepared to test their strength using a standard test method for testing the strength of joints. Each joint included a chemical vapor deposited silicon carbide endplate section having dimensions 76 mm long x 76 mm wide x 6.4 mm thick.

The endplates were made by using a conventional chemical vapor deposition method using conventional parameters. Conditions were optimized for a six triangular box production furnace. The silicon carbide was made from methyltrichlorosilane (MTS) in an inert hydrogen (H₂) and argon (Ar) atmosphere. The silicon carbide deposition conditions in each box of the furnace are in the table below.

**Table 1**

| **PROCESS PARAMETERS** | **AMOUNT** |
|---|---|
| Furnace Pressure | 200 torr* |
| Deposition Temperature | 1360° C |
| H₂ gas flow rate | 50 slpm |
| Ar gas flow rate | 52 slpm |
| MTS gas flow rate | 8.3 slpm |
| H₂ partial pressure | 91 torr* |
| Ar partial pressure | 95 torr* |
| MTS | 14 torr* |
| Deposition Rate | 1.5 µm/min. |
| H₂/MTS gas flow ratio | 6 |

| | |
|---|---|
| *1 Torr = 133,32 Pa | |

The silicon carbide was deposited on a rectangular graphite mandrel. After deposition the deposit was removed from the mandrel and machined using 220 grit diamond impregnated grinding wheels and tools to form the endplates polished to < 1 Å RMS and having the dimensions described above.

Three silicon carbide rail beams also were made using the conventional chemical vapor deposition method as used for the endplates with the conditions described in table 1. After deposition the deposits were removed from the graphite mandrels. The rail beams were 64 mm long, 14 mm wide and 20 mm high. They were machined and polished by the same method and tools as the endplates.

The rail beams were assembled to form joints with the end plates. One rail beam was joined to the endplate to form a joint having right angles. The joint was coated with 2.3 mm of chemical vapor deposited silicon carbide. The other two joints were joints which had a fillet radius of 3 mm. One had an open back radius joint as shown in Figure 7 and the second joint which had a fillet radius had a closed back radius as shown in figure 6. Both joints were secured with pins and coated with 2.3 mm of chemical vapor deposited silicon carbide. Chemical vapor deposition was done in a 1.5-m furnace. Deposition conditions are given in the table below.

**Table 2**

| **PROCESS PARAMETERS** | **AMOUNT** |
|---|---|
| Furnace Pressure | 200 torr* |
| Deposition Temperature | 1360° C |
| H₂ gas flow rate | 124 slpm |
| Ar gas flow rate | 408 slpm |
| MTS gas flow rate | 24.5 slpm |
| H₂ gas partial pressure | 44 torr* |
| Ar gas partial pressure | 147 torr* |
| MTS partial pressure | 9 torr* |
| Deposition Rate | 1.5 µm/min. |
| H₂/MTS gas flow ratio | 5 |

| | |
|---|---|
| * 1 Torr = 133,32 Pa | |

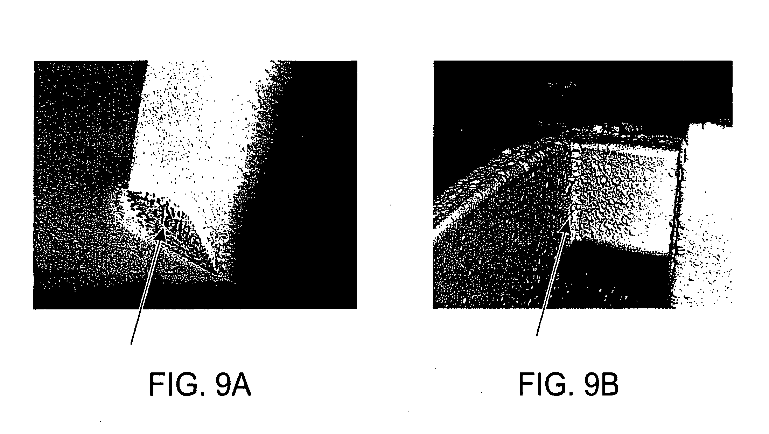

All three joints were then visually inspected for cracks. None of the joints showed any visible cracks or flaws. However, the joint with the rail at right angles to the endplate showed poor silicon carbide deposition as shown in the photograph of Figure 9A. In contrast, the joints with the fillet ratio showed complete silicon carbide coverage as shown in the photograph of Figure 9B.

Each joint was then placed in a standard Instron Mechanical Tester^{™} to test the amount of load each joint could tolerate before breaking. The endplate of the joint was secured into a fixture to hold the endplate with the rail protruding from the fixture horizontally such that the distance from the endplate to the point on the rail where the load (force) is applied was 2.5 inches. The Instron Mechanical Tester^{™} head (load cell) was then set to move at a speed of 0.02 inches/minute pushing down on the rail section. The load value in pounds and load rate (inches per minute) were recorded on a conventional chart recorder and the point at which the joint fractured was identified on the chart recorder and used to determine the load (force) on the rail that caused it to fracture.

The conventional joint with the rail beam at right angles to the endplate and with poor silicon carbide deposition cracked after a load of 158 pounds. In contrast, the joint with the open back and fillet radius and having complete silicon carbide coverage did not crack or show any flaws at 158 pounds.

The joint with the open back and fillet radius and having complete silicon carbide coverage did not fail until the load applied to it reached 189 pounds. The joint with the closed back and fillet radius and having complete silicon carbide coverage did not fail until the load applied to it reached 183 pounds. Accordingly, the joints having the fillet radius were stronger than the conventional joint where the rail beam was at a right angle to the endplate and had poor silicon carbide coverage.

## Claims

1. An apparatus (50) comprising a plurality of rods (60) secured at opposite ends to respective endplates (90) by joints (20), **characterised in that** the joints have flanges (10) with a fillet radius (1).

2. The apparatus of claim 1, wherein the joints (20) are coated with silicon carbide.

3. An apparatus according to claim 1, wherein each rod end has a tenon (125) which is inserted into an inside face (110) of the respective endplates through an elliptical port having the flange (10) with the fillet radius around its circumference, each tenon is continuous with a shoulder of the rod at each end of the rod, each shoulder has a flat surface to abut a top surface of the flange with the fillet to form an interface between the flat surface of the should and the top surface of the flange.

4. An apparatus according to claim 1, wherein the joints have a four sided flange with a fillet radius, each rod end has a tenon which is inserted into an inside face of the respective endplates through a rectangular port having the four sided flange with the fillet radius, each tenon is continuous with a shoulder of the rod at each end of the rod, each shoulder has a flat surface to abut a top surface of the flange with the fillet radius to form an interface between the flat surface of the shoulder and the top surface of the flange.

5. An apparatus according to claim 1, wherein the joints have a three sided flange with a fillet radius, each rod has a tenon which is inserted into a port in a side of the endplate, the three sided flange with the fillet radius defines the port on an inside surface of the endplate, each tenon is continuous with a shoulder of the rod at each end of the rod, each shoulder has a flat surface to abut a top surface of the flange with the fillet radius to form an interface between the flat surface of the shoulder and the top surface of the flange.

6. An apparatus according to claim 1, wherein the joints have a three sided flange with a fillet radius, each rod has a tenon with the three sided flange with the fillet radius, each rod is inserted into a port in a side of the endplate such that each side of the three sided flange forms an interface with a side of the port.

## Patentansprüche

1. Vorrichtung (50), umfassend eine Vielzahl von Stäben bzw. Stangen (60), gesichert an gegenüberliegenden Enden an entsprechende Endplatten (90) durch Verbindungen (20), **dadurch gekennzeichnet, daß** die Verbindungen Flansche (10) mit einem Abrundungsdurchmesser (r) aufweisen.

2. Vorrichtung gemäß Anspruch 1, wobei die Verbindungen (20) mit Siliciumcarbid beschichtet sind.

3. Vorrichtung gemäß Anspruch 1, wobei jedes Stangenende einen Zapfen (125) aufweist, welcher in eine Innenfläche (110) der entsprechenden Endplatten über einen elliptischen Anschluß bzw. Eingang mit dem Flansch (10) mit dem Abrundungsdurchmesser um dessen Umfang insertiert ist, wobei jeder Zapfen kontinuierlich mit einer Schulter der Stange bei jedem Ende der Stange ist, jede Schulter eine flache Oberfläche aufweist, um an eine obere Oberfläche des Flansches mit der Abrundung aneinander zu grenzen, um eine Grenzfläche zwischen der flachen Oberfläche der Schulter und der oberen Oberfläche des Flansches zu bilden.

4. Vorrichtung gemäß Anspruch 1, wobei die Verbindungen einen vierseitigen Flansch mit einem Abrundungsradius aufweisen, wobei jedes Stangenende einen Zapfen aufweist, welcher in eine innere Fläche der entsprechenden Endplatten durch einen rechteckigen Anschluß bzw. Eingang mit dem vierseitigen Flansch mit dem Abrundungsradius insertiert ist, wobei jeder Zapfen kontinuierlich mit einer Schulter der Stange bei jedem Ende der Stange ist, jede Schulter eine flache Oberfläche aufweist, um an eine obere Oberfläche des Flansches mit dem Abrundungsradius aneinander zu grenzen, um eine Grenzfläche zwischen der flachen Oberfläche der Schulter und der oberen Oberfläche des Flansches zu bilden.

5. Vorrichtung gemäß Anspruch 1, wobei die Verbindungen einen dreiseitigen Flansch mit einem Abrundungsradius aufweisen, wobei jede Stange einen Zapfen aufweist, welcher in einen Anschluß bzw. Eingang in einer Seite der Endplatte insertiert ist, wobei der dreiseitige Flansch mit dem Abrundungsradius den Einlaß auf einer inneren Oberfläche der Endplatte definiert, jeder Zapfen kontinuierlich mit einer Schulter der Stange an jedem Ende der Stange ist, jede Schulter eine flache Oberfläche aufweist, um an eine obere Oberfläche des Flansches mit dem Abrundungsradius aneinander zu grenzen, um eine Grenzfläche zwischen der flachen Oberfläche der Schulter und der oberen Oberfläche des Flansches zu bilden.

6. Vorrichtung gemäß Anspruch 1, wobei die Verbindungen einen dreiseitigen Flansch mit einem Abrundungsradius aufweisen, wobei jede Stange einen Zapfen mit dem dreiseitigen Flansch mit dem Abrundungsradius aufweist, jede Stange in einen Anschluß bzw. Eingang in einer Seite der Endplatte derart insertiert ist, daß jede Seite des dreiseitigen Flansches eine Grenzfläche mit einer Seite des Anschlußes bzw. Eingangs bildet.

## Revendications

1. Appareil (50) comprenant une pluralité de tiges (60) fixées à leurs extrémités opposées à des plaques d'extrémité respectives (90) par des jointures (20), **caractérisé en ce que** les jointures ont des bords (10) ayant un congé de raccordement (r).

2. Appareil selon la revendication 1, dans lequel les jointures (20) sont revêtues de carbure de silicium.

3. Appareil selon la revendication 1, dans lequel chaque extrémité de tige a un tenon (125) qui est inséré dans une face intérieure (110) des plaques d'extrémité respectives à travers un orifice elliptique ayant le bord (10) avec le congé de raccordement autour de sa circonférence, chaque tenon venant en continuation d'un épaulement de la tige à chaque extrémité de la tige, chaque épaulement ayant une surface plate destinée à venir en butée contre une surface de dessus du bord avec le congé de raccordement pour former une interface entre la surface plate de l'épaulement et la surface de dessus du bord.

4. Appareil selon la revendication 1, dans lequel les jointures ont un bord à quatre côtés avec un congé de raccordement, chaque extrémité de tige ayant un tenon qui est inséré dans une face intérieure des plaques d'extrémité respectives à travers un orifice rectangulaire pourvu du bord à quatre côté avec le congé de raccordement, chaque tenon venant en continuation d'un épaulement de la tige à chaque extrémité de la tige, chaque épaulement ayant une surface plate destinée à venir en butée contre une surface de dessus du bord avec le congé de raccordement pour former une interface entre la surface plate de l'épaulement et la surface de dessus du bord.

5. Appareil selon la revendication 1, dans lequel les jointures ont un bord à trois côtés avec un congé de raccordement, chaque tige ayant un tenon qui est inséré dans un orifice formé dans un côté de la plaque d'extrémité, le bord à trois côtés avec le congé de raccordement définissant l'orifice sur une surface intérieure de la plaque extrémité, chaque tenon venant en continuation d'un épaulement de la tige à chaque extrémité de la tige, chaque épaulement ayant une surface plate destinée à venir en butée contre une surface de dessus du bord avec le congé de raccordement pour former une interface entre la surface plate de l'épaulement et la surface de dessus du bord.

6. Appareil selon la revendication 1, dans lequel les jointures ont un bord à trois côtés avec un congé de raccordement, chaque tige ayant un tenon pourvu du bord à trois côtés avec le congé de raccordement, chaque tige étant insérée dans un orifice formé dans un côté de la plaque d'extrémité de telle sorte que chaque côté du bord à trois côté forme une interface avec un côté de l'orifice.
